# EUROPEAN PATENT APPLICATION

(11) **EP 4 514 108 A1**
(43) Date of publication of application: **26.02.2025**
(21) Application number: 24194343.0
(22) Date of filing: 13.08.2024
(51) Int. Cl.: H10K 59/38, H10K 59/80

(54) **ELECTRONIC DEVICE**

(30) Priority: 21.08.2023 KR 20230109383
(71) Applicant: Samsung Display Co., Ltd., Gyeonggi-Do (KR)
(72) Inventor: HONG, Sang Min, Yongin-si, Gyeonggi-Do (KR); KIM, Hyomin, Yongin-si, Gyeonggi-Do (KR); SUNG, Sijin, Yongin-si, Gyeonggi-Do (KR)
(74) Representative: Gulde & Partner

(57) **Abstract**

An electronic device includes: a display layer including a plurality of light emitting elements in which a plurality of light emitting areas are defined, and an optical layer disposed on the display layer. The optical layer includes: a light shielding layer in which a plurality of openings corresponding to the plurality of light emitting areas are defined, and a plurality of color filters arranged to correspond to the plurality of openings. The display layer or the optical layer further includes a brightness control layer overlapping a first light emitting area among the plurality of light emitting areas and a first opening among the plurality of openings in a plan view, and the brightness control layer includes a first edge and a second edge surrounding the first edge, the first edge overlaps the first light emitting area, and the second edge overlaps the light shielding layer in the plan view.

## Description

### BACKGROUND

Embodiments of the present disclosure described herein relate to an electronic device having improved display quality.

Multimedia electronic devices such as a television ("TV"), a mobile phone, a tablet computer, a navigation system, and a game console include electronic devices for displaying images. The electronic devices may include organic light emitting electronic devices ("OLEDs"). An OLED includes a light emitting element, and the light emitting element may generate a light by recombination of electrons and holes. An OLED has a fast response speed and is driven with low power consumption.

### SUMMARY

Embodiments of the present disclosure provide an electronic device having improved display quality by reducing a color deviation according to a viewing angle.

According to an embodiment, an electronic device includes: a display layer including a plurality of light emitting elements in which a plurality of light emitting areas are defined, and an optical layer disposed on the display layer, where the optical layer includes: a light shielding layer in which a plurality of openings corresponding to the plurality of light emitting areas are defined, and a plurality of color filters arranged to correspond to the plurality of openings, the display layer or the optical layer further includes a brightness control layer overlapping a first light emitting area among the plurality of light emitting areas and a first opening among the plurality of openings in a plan view, and the brightness control layer includes a first edge and a second edge surrounding the first edge, the first edge overlaps the first light emitting area in a plan view, and the second edge overlaps the light shielding layer in a plan view.

A transmittance of the brightness control layer may be greater than a transmittance of the light shielding layer and smaller than 100 percent (%).

The brightness control layer may include a first portion having a first transmittance and a second portion having a second transmittance lower than the first transmittance.

The first portion may be adjacent to the first edge, and the second portion may be adjacent to the second edge.

The brightness control layer may overlap a side wall of the light shielding layer defining the first opening in the plan view.

A first part of the brightness control layer may be covered by the light shielding layer, and a second part of the brightness control layer may be covered by a first color filter among the plurality of color filters.

A maximum thickness of the brightness control layer may be smaller than a maximum thickness of the light shielding layer.

The display layer may further include: a base layer, a circuit layer disposed on the base layer, an element layer disposed on the circuit layer and including the plurality of light emitting elements, and an encapsulation layer disposed on the element layer, and the brightness control layer may be disposed inside the display layer or on the encapsulation layer.

Each of the plurality of light emitting elements may include a first electrode, a light emitting layer disposed on the first electrode, and a second electrode disposed on the light emitting layer, the element layer may further include a pixel defining film in which a pixel defining opening overlapping a portion of the first electrode in the plan view is defined, and a size of the pixel defining opening may be larger than a size of an area surrounded by the first edge of the brightness control layer in the plan view.

The plurality of light emitting elements may include a first light emitting element in which the first light emitting area is defined, a second light emitting element in which a second light emitting area is defined, and a third light emitting element in which a third light emitting area is defined, the plurality of openings may include the first opening overlapping the first light emitting area, a second opening overlapping the second light emitting area, and a third opening overlapping the third light emitting area, and the first light emitting area may emit a red light, the second light emitting area may emit a green light, and the third light emitting area may emit a blue light.

A shape of each of the plurality of openings may be circular in the plan view.

A shape of the brightness control layer may be a ring shape in the plan view.

According to an embodiment, an electronic device includes: a base layer, a circuit layer disposed on the base layer, an element layer disposed on the circuit layer and including a light emitting element in which a light emitting area is defined, an encapsulation layer disposed on the element layer, a light shielding layer which is disposed on the encapsulation layer and in which an opening corresponding to the light emitting area is defined, a color filter that is disposed on the light shielding layer and covers the opening, and a brightness control layer disposed between the light emitting element and the opening, where a transmittance of the brightness control layer is higher than a transmittance of the light shielding layer.

The brightness control layer may overlap a side wall of the light shielding layer defining the opening and have a ring shape in a plan view.

The brightness control layer may be disposed between the light shielding layer and the encapsulation layer, a first part of the brightness control layer may be covered by the light shielding layer, and a second part of the brightness control layer may be covered by the color filter.

A maximum thickness of the brightness control layer may be smaller than a maximum thickness of the light shielding layer.

The brightness control layer may be spaced apart from the light shielding layer.

The brightness control layer may include a first portion having a first transmittance and a second portion having a second transmittance lower than the first transmittance.

The brightness control layer may include a first edge and a second edge surrounding the first edge, the first edge may overlap the light emitting area, and the second edge may overlap the light shielding layer in a plan view.

The light emitting element may include a first electrode, a light emitting layer disposed on the first electrode, and a second electrode disposed on the light emitting layer, the element layer may further include a pixel defining film in which a pixel defining opening overlapping a portion of the first electrode in the plan view is defined, and a size of the pixel defining opening may be larger than a size of an area surrounded by the first edge of the brightness control layer in the plan view.

### BRIEF DESCRIPTION OF THE FIGURES

The above and other aspects and features of the present disclosure will become apparent by describing in detail embodiments thereof with reference to the accompanying drawings.
FIG. 1 is a perspective view of an electronic device according to an embodiment of the present disclosure.
FIG. 2 is a perspective view of the electronic device according to an embodiment of the present disclosure.
FIG. 3 is a cross-sectional view of the electronic device according to an embodiment of the present disclosure.
FIG. 4 is an enlarged plan view illustrating a partial area of a display layer according to an embodiment of the present disclosure.
FIG. 5 is a cross-sectional view illustrating a portion of the electronic device according to an embodiment of the present disclosure.
FIG. 6 is a cross-sectional view illustrating a portion of the electronic device according to an embodiment of the present disclosure.
FIG. 7 is a cross-sectional view illustrating a portion of the electronic device according to an embodiment of the present disclosure.
FIG. 8 is a cross-sectional view illustrating a portion of the electronic device according to an embodiment of the present disclosure.
FIG. 9 is a cross-sectional view illustrating a portion of the electronic device according to an embodiment of the present disclosure.
FIG. 10 is a plan view illustrating some components of the electronic device according to an embodiment of the present disclosure.
FIG. 11A is a graph depicting color coordinates according to a viewing angle according to a comparative example of the present disclosure.
FIG. 11B is a graph depicting color coordinates according to a viewing angle according to an embodiment of the present disclosure.
FIG. 11C is a graph depicting color coordinates according to a viewing angle according to a comparative example of the present disclosure.

### DETAILED DESCRIPTION

In the present specification, the expression that a first component (or area, layer, part, portion, etc.) is "on", "connected with", or "coupled to" a second component means that the first component is directly on, connected with, or coupled to the second component or means that a third component is interposed therebetween.

The same reference numerals refer to the same components. Further, in the drawings, the thickness, the ratio, and the dimension of components are exaggerated for effective description of technical contents. The expression "and/or" includes one or more combinations which associated components are capable of defining. Throughout the disclosure, the expression "at least one of a, b or c" indicates only a, only b, only c, both a and b, both a and c, both b and c, all of a, b, and c, or variations thereof.

Although the terms "first", "second", etc. may be used to describe various components, the components should not be limited by the terms. The terms are only used to distinguish one component from another component. For example, without departing from the right scope of the present disclosure, a first component may be referred to as a second component, and similarly, the second component may be also referred to as the first component. Singular expressions include plural expressions unless clearly otherwise indicated in the context.

Also, the terms "under", "below", "on", "above", etc. are used to describe the correlation of components illustrated in drawings. The terms that are relative in concept are described based on a direction illustrated in drawings.

It will be understood that the terms "include", "comprise", "have", etc. specify the presence of features, numbers, steps, operations, elements, or components, described in the specification, or a combination thereof, and do not exclude in advance the presence or additional possibility of one or more other features, numbers, steps, operations, elements, or components or a combination thereof.

Term "unit" means a software component or hardware component that performs a specific function. The hardware component may include, for example, a field-programmable gate array ("FPGA") or an application-specific integrated circuit ("ASIC"). The software component may refer to an executable code and/or data used by the executable code in an addressable storage medium. Thus, the software components may be, for example, object-oriented software components, class components, and task components, and may include processes, functions, attributes, procedures, subroutines, program code segments, drivers, firmware, microcodes, circuits, data, database, data structures, tables, arrays, or variables.

Unless otherwise defined, all terms (including technical terms and scientific terms) used in the present specification have the same meaning as commonly understood by those skilled in the art to which the present disclosure belongs. Furthermore, terms such as terms defined in the dictionaries commonly used should be interpreted as having a meaning consistent with the meaning in the context of the related technology, and should not be interpreted in overly ideal or overly formal meanings unless explicitly defined herein.

Hereinafter, an embodiment of the present disclosure will be described with reference to accompanying drawings.

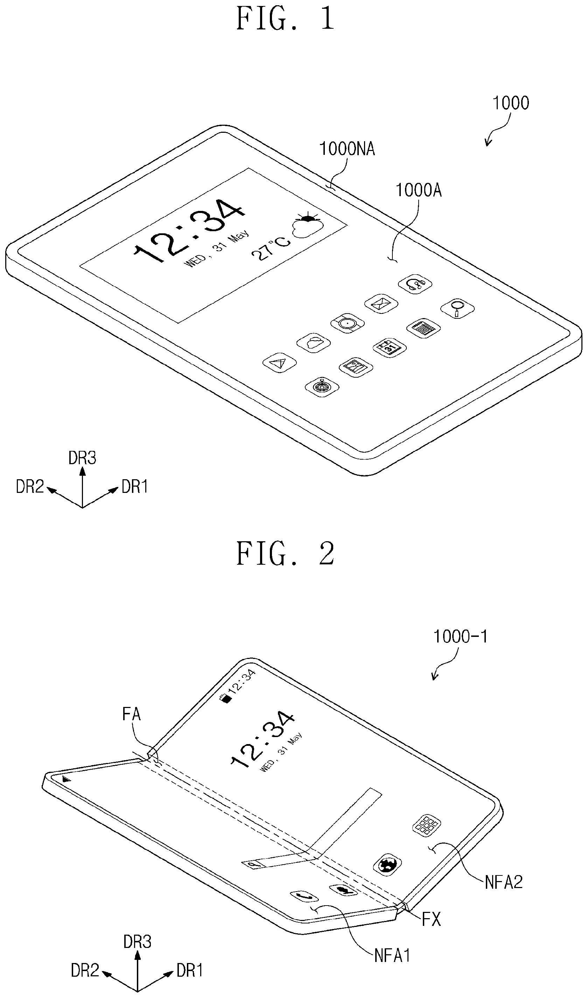

FIG. 1 is a perspective view of an electronic device 1000 according to an embodiment of the present disclosure.

Referring to FIG. 1, the electronic device 1000 may be a device that is activated according to an electric signal. For example, the electronic device 1000 may be a mobile phone, a portable mobile phone, a laptop, a television, a tablet, a vehicle navigation system, a game console, or a wearable device, but the present disclosure is not limited thereto. The wearable device, which is a device worn on a body of a user, may include a head mounted display ("HMD") that implements eXtended reality ("XR"). FIG. 1 exemplarily illustrates that the electronic device 1000 is a mobile phone.

An active area 1000A and a peripheral area 1000NA may be defined in the electronic device 1000. The electronic device 1000 may display an image through the active area 1000A. The active area 1000A may include a plane defined by a first direction DR1 and a second direction DR2. The peripheral area 1000NA may surround a periphery of the active area 1000A. In an embodiment of the present disclosure, the peripheral area 1000NA may be omitted.

A thickness direction of the electronic device 1000 may be parallel to a third direction DR3 intersecting the first direction DR1 and the second direction DR2. Thus, front surfaces (or upper surfaces) and rear surfaces (or lower surfaces) of members constituting the electronic device 1000 may be defined based on the third direction DR3.

FIG. 2 is a perspective view of an electronic device 1000-1 according to an embodiment of the present disclosure.

Referring to FIG. 2, the electronic device 1000-1 may include a folding area FA and a plurality of non-folding areas NFA1 and NFA2. The non-folding areas NFA1 and NFA2 may include the first non-folding area NFA1 and the second non-folding area NFA2. The folding area FA may be disposed between the first non-folding area NFA1 and the second non-folding area NFA2. The folding area FA may refer to a foldable area, and the first and second non-folding areas NFA1 and NFA2 may refer to first and second non-foldable areas.

As illustrated in FIG. 2, the folding area FA may be folded with respect to a folding axis FX parallel to the second direction DR2. In a state in which the electronic device 1000-1 is folded, the folding area FA has a predetermined curvature and a predetermined radius of curvature. The first non-folding area NFA1 and the second non-folding area NFA2 may face each other, and the electronic device 1000-1 may be inner-folded so that a display surface is not exposed to the outside.

In an embodiment of the present disclosure, the electronic device 1000-1 may be outer-folded so that the display surface is exposed to the outside. In an embodiment of the present disclosure, the electronic device 1000-1 may be inner-folded or outer-folded in a state in which the electronic device 1000-1 is unfolded, but the present disclosure is not limited thereto.

FIG. 2 exemplarily illustrates that one folding axis FX is defined in the electronic device 1000-1, but the present disclosure is not limited thereto. For example, a plurality of folding axes may be defined in the electronic device 1000-1, and the electronic device 1000-1 may be inner-folded or outer-folded in an unfolded state on each of the plurality of folding axes.

FIGS. 1 and 2 exemplarily illustrate the bar type electronic device 1000 and the foldable type electronic device 1000-1, but the present disclosure is not limited thereto. For example, the following descriptions may be applied to various electronic devices such as a curved electronic device, a rollable electronic device, or a slidable electronic device.

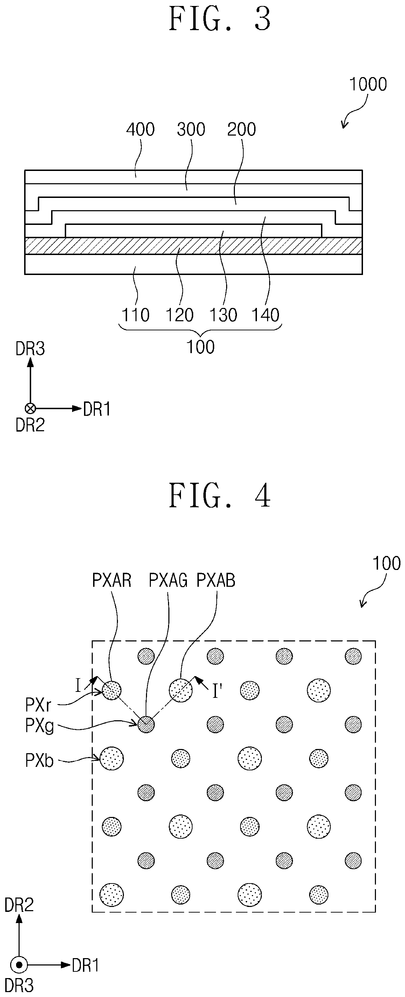

FIG. 3 is a cross-sectional view of the electronic device 1000 according to an embodiment of the present disclosure.

Referring to FIG. 3, the electronic device 1000 may include a display layer 100, a sensor layer 200, an optical layer 300, and a window 400. However, this is merely an example, and the electronic device 1000 may not include the optical layer 300 and the window 400.

The display layer 100 may include a base layer 110, a circuit layer 120, an element layer 130, and an encapsulation layer 140.

The base layer 110 may be a member that provides a base surface on which the circuit layer 120 is disposed. The base layer 110 may be a glass substrate, a metal substrate, a silicon substrate, a polymer substrate, or the like. However, an embodiment is not limited thereto, and the base layer 110 may be an inorganic layer, an organic layer, or a composite material layer.

The circuit layer 120 may be disposed on the base layer 110. The circuit layer 120 may include an insulating layer, a semiconductor pattern, a conductive pattern, a signal line, and/or the like. The insulating layer, a semiconductor layer, and a conductive layer are formed on the base layer 110 in a manner such as coating and deposition, and thereafter, the insulating layer, the semiconductor layer, and the conductive layer may be selectively patterned through a plurality of photolithography processes. Thereafter, the semiconductor pattern, the conductive pattern, and the signal line included in the circuit layer 120 may be formed.

The element layer 130 may be disposed on the circuit layer 120. The element layer 130 may include a light emitting element. For example, the element layer 130 may include an organic light emitting material, an inorganic light emitting material, an organic-inorganic light emitting material, a quantum dot, a quantum rod, a micro-light emitting diode ("LED"), or a nano-LED.

The encapsulation layer 140 may be disposed on the element layer 130. The encapsulation layer 140 may protect the element layer 130 from foreign substances such as moisture, oxygen, and dust particles.

The sensor layer 200 may be disposed on the display layer 100. The sensor layer 200 may be formed on the display layer 100 through a continuous process. In this case, it may be expressed that the sensor layer 200 is directly disposed on the display layer 100. The aspect that the sensor layer 200 is directly disposed on the display layer 100 may mean that a third component is not disposed between the sensor layer 200 and the display layer 100. That is, a separate adhesive member may not be disposed between the sensor layer 200 and the display layer 100. Alternatively, the sensor layer 200 may be coupled to the display layer 100 through an adhesive member. The adhesive member may include a general adhesive or a pressure-sensitive adhesive.

The optical layer 300 may be disposed on the sensor layer 200. The optical layer 300 may reduce reflectance of an external light input from the outside of the electronic device 1000. The optical layer 300 may be directly disposed on the sensor layer 200. However, the present disclosure is not limited thereto, and an adhesive member may be disposed between the optical layer 300 and the sensor layer 200.

The window 400 may be disposed on the optical layer 300. An adhesive member may be disposed between the optical layer 300 and the window 400, but the present disclosure is not particularly limited thereto. The window 400 may include an optically transparent insulating material. For example, the window 400 may include a glass or a plastic. The window 400 may have a multi-layer structure or a single-layer structure. For example, the window 400 may include a plurality of plastic films coupled through an adhesive or include a glass substrate and a plastic substrate coupled through an adhesive.

FIG. 4 is an enlarged plan view illustrating a portion of the display layer 100 according to an embodiment of the present disclosure. As used herein, the "plan view" is a view in the thickness direction (i.e., third direction DR3) of the electronic device 1000.

Referring to FIG. 4, the display layer 100 may include a plurality of pixels PXr, PXg, and PXb. The pixels PXr, PXg, and PXb may include the first pixel PXr, the second pixel PXg, and the third pixel PXb.

A first light emitting area PXAR may be defined in the first pixel PXr, a second light emitting area PXAG may be defined in the second pixel PXg, and a third light emitting area PXAB may be defined in the third pixel PXb. Circular shapes illustrated in FIG. 4 may correspond to shapes of the first to third light emitting areas PXAR, PXAG, and PXAB, respectively. However, the shapes of the first to third light emitting areas PXAR, PXAG, and PXAB are not limited thereto. For example, the first to third light emitting areas PXAR, PXAG, and PXAB may have various shapes, such as a quadrangular shape, a polygonal shape, an elliptical shape, a triangular shape, or an irregular shape, on a plane.

In an embodiment of the present disclosure, the first pixel PXr and the third pixel PXb may be alternately and repeatedly arranged one by one in the first direction DR1 and the second direction DR2. The second pixel PXg may be disposed in a space between two first pixels PXr adjacent to each other in a diagonal direction and two third pixels PXb adjacent to each other in the diagonal direction. However, the arrangement relationship between the first to third pixels PXr, PXg, and PXb as illustrated in FIG. 4 is an example, and the arrangement relationship between the first to third pixels PXr, PXg, and PXb is not particularly limited thereto. The diagonal direction may be a direction between the first direction DR1 and the second direction DR2 or a direction between a direction opposite to the first direction DR1 and the second direction DR2.

In an embodiment of the present disclosure, an area of the third light emitting area PXAB may be largest, and an area of the second light emitting area PXAG may be smallest. However, the present disclosure is not particularly limited thereto. For example, areas of the first to third light emitting areas PXAR, PXAG, and PXAB may be the same or may be different from the illustrated example.

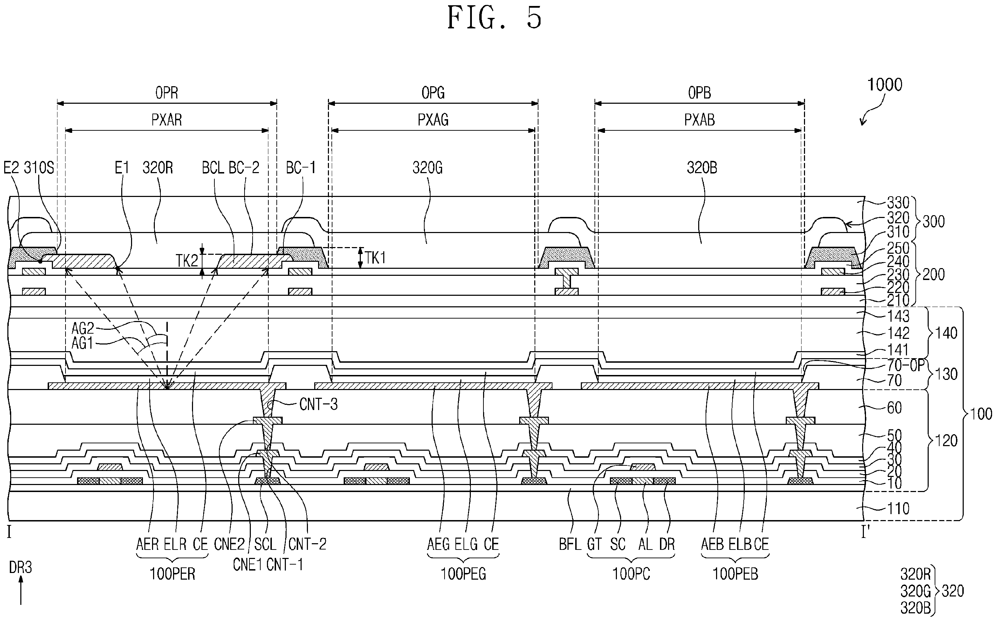

FIG. 5 is a cross-sectional view illustrating a portion of the electronic device 1000 according to an embodiment of the present disclosure. For example, FIG. 5 is a cross-sectional view including the display layer 100 along line I-I' illustrated in FIG. 4 according to an embodiment of the present disclosure.

Referring to FIG. 5, at least one inorganic layer is formed on an upper surface of the base layer 110. The inorganic layer may include at least one of aluminum oxide, titanium oxide, silicon oxide, silicon nitride, silicon oxy nitride, zirconium oxide, or hafnium oxide. The inorganic layer may be formed as multiple layers. The multi-layered inorganic layers may constitute a barrier layer and/or a buffer layer. In an embodiment, the display layer 100 is illustrated as including a buffer layer BFL.

The buffer layer BFL may improve a bonding force between the base layer 110 and the semiconductor pattern. The buffer layer BFL may include at least one of silicon oxide, silicon nitride, or silicon oxy nitride. For example, the buffer layer BFL may include a structure in which silicon oxide layers and silicon nitride layers are alternately laminated.

The semiconductor pattern may be disposed on the buffer layer BFL. The semiconductor pattern may include poly silicon. However, the present disclosure is not limited thereto, and the semiconductor pattern may include amorphous silicon, low-temperature polycrystalline silicon, or an oxide semiconductor.

FIG. 5 merely illustrates a portion of the semiconductor pattern, and the semiconductor pattern may be further disposed in another area. The semiconductor pattern may be disposed in a specific rule across the pixels. The semiconductor pattern may have a different electrical property depending on whether or not the semiconductor pattern is doped. The semiconductor pattern may include a first area having higher conductivity and a second area having lower conductivity. The first area may be doped with an N-type dopant or a P-type dopant. A P-type transistor may include a doped area doped with the P-type dopant, and an N-type transistor may include a doped area doped with the N-type dopant. The second area may be a non-doping area or may be an area doped at a concentration lower than a concentration of the first area.

A conductivity of the first area is greater than a conductivity of the second area, and the first area may substantially serve as an electrode or a signal line. The second area may substantially correspond to an active area (or a channel) of a transistor. In other words, a portion of the semiconductor pattern may be an active area of the transistor, another portion of the semiconductor pattern may be a source area or a drain area of the transistor, and still another portion of the semiconductor pattern may be a connection electrode or a connection signal line.

Each of the pixels may include a pixel circuit and a light emitting element. The pixel circuit may include a plurality of transistors and at least one capacitor. FIG. 5 exemplarily illustrates transistors 100PC and light emitting elements 100PER, 100PEG, and 100PEB included in each of the three pixels.

A source area SC, an active area AL, and a drain area DR of the transistor 100PC may be formed from the semiconductor pattern. The source area SC and the drain area DR may extend from the active area AL in opposite directions on a cross section. FIG. 5 illustrates a portion of a connection signal line SCL formed from the semiconductor pattern. Although not separately illustrated, the connection signal line SCL may be connected to the drain area DR of the transistor 100PC on a plane.

A first insulating layer 10 may be disposed on the buffer layer BFL. The first insulating layer 10 may commonly overlap the plurality of pixels and cover the semiconductor pattern in a plan view. The first insulating layer 10 may be an inorganic layer and/or an organic layer and may have a single-layer structure or a multi-layer structure. The first insulating layer 10 may include at least one of aluminum oxide, titanium oxide, silicon oxide, silicon nitride, silicon oxy nitride, zirconium oxide, or hafnium oxide. In an embodiment, the first insulating layer 10 may be a single-layer silicon oxide layer. The first insulating layer 10 and an insulating layer of the circuit layer 120, which will be described below, may be an inorganic layer and/or an organic layer, and may have a single-layer structure or a multi-layer structure. The inorganic layer may include at least one of the above-described materials, but the present disclosure is not limited thereto.

A gate GT of the transistor 100PC is disposed on the first insulating layer 10. The gate GT may be a portion of a metal pattern. The gate GT overlaps the active area AL in a plan view. The gate GT may function as a mask in a process of doping the semiconductor pattern.

A second insulating layer 20 may be disposed on the first insulating layer 10 and cover the gate GT. The second insulating layer 20 may commonly overlap the pixels in a plan view. The second insulating layer 20 may be an inorganic layer and/or an organic layer and may have a single-layer structure or a multi-layer structure. The second insulating layer 20 may include at least one of silicon oxide, silicon nitride, or silicon oxy nitride. In an embodiment, the second insulating layer 20 may have a multi-layer structure including a silicon oxide layer and a silicon nitride layer.

A third insulating layer 30 may be disposed on the second insulating layer 20. The third insulating layer 30 may have a single-layer structure or a multi-layer structure. For example, the third insulating layer 30 may have a multi-layer structure including a silicon oxide layer and a silicon nitride layer.

A first connection electrode CNE1 may be disposed on the third insulating layer 30. The first connection electrode CNE1 may be connected to the connection signal line SCL through a contact hole CNT-1 passing through the first insulating layer 10, the second insulating layer 20, and the third insulating layer 30.

A fourth insulating layer 40 may be disposed on the third insulating layer 30. The fourth insulating layer 40 may be a single-layer silicon oxide layer. A fifth insulating layer 50 may be disposed on the fourth insulating layer 40. The fifth insulating layer 50 may be an organic layer.

A second connection electrode CNE2 may be disposed on the fifth insulating layer 50. The second connection electrode CNE2 may be connected to the first connection electrode CNE1 through a contact hole CNT-2 passing through the fourth insulating layer 40 and the fifth insulating layer 50.

A sixth insulating layer 60 may be disposed on the fifth insulating layer 50 to cover the second connection electrode CNE2. The sixth insulating layer 60 may be an organic layer.

The element layer 130 may be disposed on the circuit layer 120. The element layer 130 may include the light emitting elements 100PER, 100PEG, and 100PEB. For example, each of the light emitting elements 100PER, 100PEG, and 100PEB may include an organic light emitting material, an inorganic light emitting material, an organic-inorganic light emitting material, a quantum dot, a quantum rod, a micro-light emitting diode (LED), or a nano-LED. Hereinafter, it will be described that each of the light emitting elements 100PER, 100PEG, and 100PEB is an organic light emitting element, but the present disclosure is not particularly limited thereto.

The light emitting elements 100PER, 100PEG, and 100PEB may include the first light emitting element 100PER, the second light emitting element 100PEG, and the third light emitting element 100PEB. The first light emitting element 100PER may include a first pixel electrode AER, a first light emitting layer ELR, and a common electrode CE. The second light emitting element 100PEG may include a second pixel electrode AEG, a second light emitting layer ELG, and the common electrode CE. The third light emitting element 100PEB may include a third pixel electrode AEB, a third light emitting layer ELB, and the common electrode CE. The common electrode CE included in the first to third light emitting elements 100PER, 100PEG, and 100PEB may be provided in an integrated shape. The first pixel electrode AER, the second pixel electrode AEG, and the third pixel electrode AEB may be referred to as a first electrode or an anode. The common electrode CE may be referred to as a second electrode and a cathode.

Hereinafter, the first light emitting element 100PER will be representatively described. Descriptions of the second light emitting element 100PEG and the third light emitting element 100PEB may be substantially the same. Hereinafter, the first pixel electrode AER is referred to as the first electrode AER, the first light emitting layer ELR is referred to as the light emitting layer ELR, and the common electrode CE is referred to as the second electrode CE.

The first electrode AER may be disposed on the sixth insulating layer 60. The first electrode AER may be connected to the second connection electrode CNE2 through a contact hole CNT-3 passing through the sixth insulating layer 60.

A pixel defining film 70 may be disposed on the sixth insulating layer 60 and may cover a portion of the first electrode AER. A pixel defining opening 70-OP is defined in the pixel defining film 70. The pixel defining opening 70-OP of the pixel defining film 70 exposes at least a portion of the first electrode AER.

The active area 1000A (see FIG. 1) may include the light emitting areas PXAR, PXAG, and PXAB and non-light emitting areas adjacent to the light emitting areas PXAR, PXAG, and PXAB. The non-light emitting areas may surround the light emitting areas PXAR, PXAG, and PXAB. In an embodiment, the light emitting areas PXAR, PXAG, and PXAB may include the first light emitting area PXAR, the second light emitting area PXAG, and the third light emitting area PXAB. The first to third light emitting areas PXAR, PXAG, and PXAB may be defined to correspond to partial areas of the first electrodes AER, AEG, and AEB, respectively. The first light emitting area PXAR may emit a red light, the second light emitting area PXAG may emit a green light, and the third light emitting area PXAB may emit a blue light.

The light emitting layers ELR, ELG, and ELB may be arranged on the first electrodes AER, AEG, and AEB, respectively. The light emitting layer ELR may be disposed in an area corresponding to the pixel defining opening 70-OP. That is, the light emitting layers ELR, ELG, and ELB may be separately disposed in the pixels, respectively. When the light emitting layers ELR, ELG, and ELB are formed separately in the pixels, each of the light emitting layers ELR, ELG, and ELB may emit a light having at least one of a blue color, a red color, or a green color. However, the present disclosure is not limited thereto, and the light emitting layers ELR, ELG, and ELB may be connected to each other and may be commonly included in the plurality of light emitting elements. In this case, the light emitting layers ELR, ELG, and ELB may provide a blue light or white light.

The second electrode CE may be disposed on the light emitting layers ELR, ELG, and ELB. The second electrode CE may have an integral shape and may be commonly included in the plurality of pixels.

A hole control layer may be disposed between the first electrodes AER, AEG, and AEB and the light emitting layers ELR, ELG, and ELB. The hole control layer may include a hole transport layer and may further include a hole injection layer. An electron control layer may be disposed between the light emitting layers ELR, ELG, and ELB and the second electrode CE. The electron control layer may include an electron transport layer and may further include an electron injection layer. The hole control layer and the electron control layer may be commonly disposed in the plurality of pixels by using an open mask or an inkjet process.

The encapsulation layer 140 may be disposed on the element layer 130. The encapsulation layer 140 may include a first inorganic layer 141, an organic layer 142, and a second inorganic layer 143 sequentially laminated, but layers constituting the encapsulation layer 140 are not limited thereto. The first and second inorganic layers 141 and 143 may protect the element layer 130 from moisture and oxygen, and the organic layer 142 may protect the element layer 130 from foreign substances such as dust particles. The first and second inorganic layers 141 and 143 may include a silicon nitride layer, a silicon oxy nitride layer, a silicon oxide layer, a titanium oxide layer, an aluminum oxide layer, or the like. The organic layer 142 may include an acryl-based organic layer, but the present disclosure is not particularly limited thereto.

The sensor layer 200 may be disposed on the display layer 100. The sensor layer 200 may be referred to as a sensor, an input sensing layer, or an input sensing panel. The sensor layer 200 may include a sensor base layer 210, a first sensor conductive layer 220, a sensor insulating layer 230, a second sensor conductive layer 240, and a sensor cover layer 250.

The sensor base layer 210 may be directly disposed on the display layer 100. The sensor base layer 210 may be an inorganic layer including at least one of silicon nitride, silicon oxy nitride, or silicon oxide. Alternatively, the sensor base layer 210 may be an organic layer including an epoxy resin, an acrylic resin, or an imide-based resin. The sensor base layer 210 may have a single-layer structure or have a multi-layer structure in which layers are laminated in the third direction DR3.

Each of the first sensor conductive layer 220 and the second sensor conductive layer 240 may have a single-layer structure or have a multi-layer structure in which layers are laminated in the third direction DR3.

The conductive layer having the single-layer structure may include a metal layer or a transparent conductive layer. The metal layer may include molybdenum (Mo), silver (Ag), titanium (Ti), copper (Cu), aluminum (Al), or alloys thereof. The transparent conductive layer may include a transparent conductive oxide such as indium tin oxide, indium zinc oxide, zinc oxide, or indium zinc tin oxide. In addition, the transparent conductive layer may include a conductive polymer such as poly(3,4-ethylenedioxythiophene) ("PEDOT"), a metal nanowire, graphene, or the like.

The conductive layer having the multi-layer structure may include metal layers. The metal layers may have, for example, a three-layer structure of titanium/aluminum/titanium. The conductive layer having the multi-layer structure may include at least one metal layer and at least one transparent conductive layer.

The sensor insulating layer 230 may be disposed between the first sensor conductive layer 220 and the second sensor conductive layer 240. The sensor insulating layer 230 may include an inorganic film. The inorganic film may include at least one of aluminum oxide, titanium oxide, silicon oxide, silicon nitride, silicon oxy nitride, zirconium oxide, or hafnium oxide.

Alternatively, the sensor insulating layer 230 may include an organic film. The organic film may include at least one of an acryl-based resin, a methacrylate-based resin, a polyisoprene-based resin, a vinyl-based resin, an epoxy-based resin, a urethane-based resin, a cellulose-based resin, a siloxane-based resin, a polyimide-based resin, a polyamide-based resin, or a perylene-based resin.

The sensor cover layer 250 may be disposed on the sensor insulating layer 230 and cover the second sensor conductive layer 240. The second sensor conductive layer 240 may include a conductive pattern. The sensor cover layer 250 may cover the conductive pattern to reduce or eliminate a probability of causing damage to the conductive pattern in a subsequent process. The sensor cover layer 250 may include an inorganic material. For example, the sensor cover layer 250 may include silicon nitride, but the present disclosure is not particularly limited thereto. In an embodiment of the present disclosure, the sensor cover layer 250 may be omitted.

The optical layer 300 may be disposed on the sensor layer 200. The optical layer 300 may include a light shielding layer 310, a plurality of color filters 320, and a planarization layer 330.

The light shielding layer 310 may be disposed to overlap the conductive pattern of the second sensor conductive layer 240 in a plan view. The sensor cover layer 250 may be disposed between the light shielding layer 310 and the second sensor conductive layer 240. The light shielding layer 310 may prevent reflection of an external light by the second sensor conductive layer 240. A material constituting the light shielding layer 310 is not particularly limited as long as the material absorbs a light. The light shielding layer 310 is a layer having a black color, and in an embodiment, the light shielding layer 310 may include a black coloring agent. The black coloring agent may include black dye and black pigment. The black coloring agent may include carbon black, metal such as chromium, or an oxide thereof.

A plurality of openings OPR, OPG, and OPB may be defined in the light shielding layer 310. The openings OPR, OPG, and OPB may overlap the first to third light emitting layers ELR, ELG, and ELB, respectively, in a plan view and may be referred to as first to third openings OPR, OPG, and OPB. The color filters 320 may include a first color filter 320R, a second color filter 320G, and a third color filter 320B. The first to third color filters 320R, 320G, and 320B may be arranged to correspond to the first to third openings OPR, OPG, and OPB, respectively. The first to third color filters 320R, 320G, and 320B may transmit lights provided from the first to third light emitting layers ELR, ELG, and ELB overlapping the first to third color filters 320R, 320G, and 320B in a plan view.

The planarization layer 330 may cover the light shielding layer 310 and the color filters 320. The planarization layer 330 may include an organic material, and a flat surface may be provided to an upper surface of the planarization layer 330. In an embodiment, the planarization layer 330 may be omitted.

In an embodiment of the present disclosure, the optical layer 300 may include a reflection adjustment layer instead of the color filters 320. For example, in the illustration of FIG. 5, the color filters 320 may be omitted, and the reflection adjustment layer may be added to a place in which the color filters 320 are omitted. The reflection adjustment layer may selectively absorb a light having a partial band among a light reflected from an inside of the display layer and/or the electronic device or a light input from an outside of the display layer and/or the electronic device.

In an embodiment of the present disclosure, at least one of the display layer 100 or the optical layer 300 may further include a brightness control layer BCL. FIG. 5 exemplarily illustrates that the optical layer 300 further includes the brightness control layer BCL.

In an embodiment of the present disclosure, the brightness control layer BCL may be provided to improve white angle difference ("WAD") characteristics of the electronic device 1000. The WAD is an item that evaluates a change in white characteristics according to an observation angle. For example, the WAD characteristics may be evaluated by measuring the amount of change in the brightness and the amount of change in color coordinates according to a viewing angle compared to those when observed in a direction perpendicular to a screen, for example, the third direction DR3. When the WAD characteristics are improved, display quality of the electronic device 1000 may be effectively improved.

In an embodiment of the present disclosure, the brightness control layer BCL may overlap the first light emitting area PXAR and may not overlap the second light emitting area PXAG and the third light emitting area PXAB in a plan view. The brightness control layer BCL may be provided to control brightness of a light traveling between a first angle AG1 and a second angle AG2. For example, the first angle AG1 may be 60 degrees and the second angle AG2 may be 30 degrees, but the present disclosure is not particularly limited thereto.

In an embodiment of the present disclosure, transmittance of the brightness control layer BCL may be smaller than 100 percent (%) and may be higher than transmittance of the light shielding layer 310. The transmittance refers to "light transmittance". For example, the transmittance of the brightness control layer BCL may be greater than 82 percent and smaller than 100 percent and may be, for example, about 88 percent. However, this is merely an example, and the present disclosure is not particularly limited thereto. The brightness control layer BCL may adjust a color sense by reducing the brightness of a light provided from the first light emitting area PXAR at a specific angle. The brightness control layer BCL may be referred to as a color control layer, a color adjustment layer, a brightness adjustment layer, a brightness compensation layer, a color compensation layer, a semi-transparent layer, or translucent layer.

In an embodiment of the present disclosure, the brightness control layer BCL may be provided to overlap the first light emitting area PXAR among the first to third light emitting areas PXAR, PXAG, and PXAB in a plan view. Further, the brightness control layer BCL may overlap the first opening OPR among the first to third openings OPR, OPG, and OPB and may not overlap the second and third openings OPG and OPB in a plan view. However, the present disclosure is not particularly limited thereto. For example, when the brightness of a light provided from the second light emitting area PXAG or the third light emitting area PXAB is controlled, a position of the brightness control layer BCL may be changed.

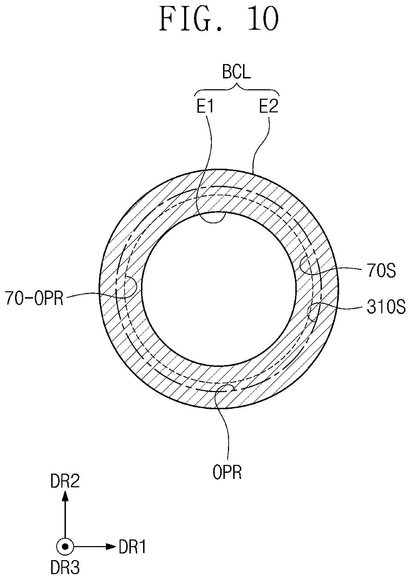

In an embodiment of the present disclosure, the brightness control layer BCL may include a first edge E1 and a second edge E2. The second edge E2 may surround the first edge E1. The first edge E1 may be an inner edge E1 and the second edge E2 may be an outer edge E2 outside and opposite to the first edge E1 in a plan view (See FIG. 10). The first edge E1 may overlap the first light emitting area PXAR, and the second edge E2 may overlap the light shielding layer 310 in a plan view. Thus, the brightness control layer BCL may overlap a side wall 310S of the light shielding layer 310, which defines the first opening OPR in a plan view.

In an embodiment of the present disclosure, the brightness control layer BCL may be disposed between the first light emitting element 100PER and the first opening OPR. The brightness control layer BCL may be disposed between the light shielding layer 310 and the encapsulation layer 140. In detail, the brightness control layer BCL may be disposed between the light shielding layer 310 and the sensor layer 200, and the brightness control layer BCL may be in contact with the light shielding layer 310 and the sensor layer 200.

In an embodiment of the present disclosure, the brightness control layer BCL may include a first part BC-1 and a second part BC-2. The first part BC-1 may be covered by the light shielding layer 310, and the second part BC-2 may not be covered by the light shielding layer 310. A first thickness TK1 (i.e., maximum thickness) of the light shielding layer 310 may be greater than a second thickness TK2 (i.e., maximum thickness) of the brightness control layer BCL. For example, the first thickness TK1 and the second thickness TK2 may be the maximum thickness. The second portion BC-2 of the brightness control layer BCL may be covered by the first color filter 320R.

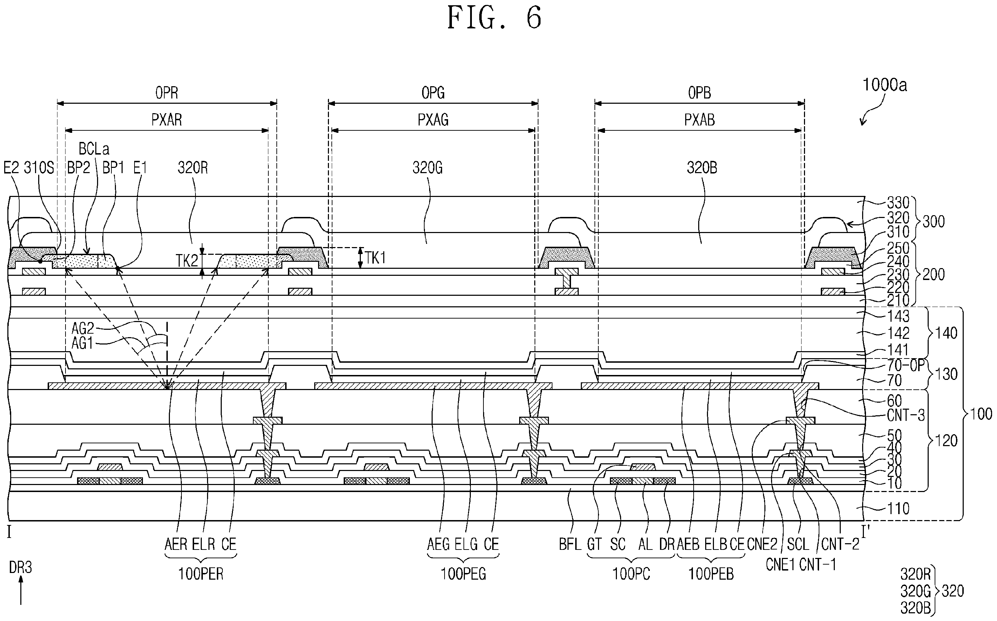

FIG. 6 is a cross-sectional view illustrating a portion of an electronic device 1000a according to an embodiment of the present disclosure. In the description of FIG. 6, the same components as those described in FIG. 5 are designated by the same reference numerals, and a description thereof will be omitted.

Referring to FIG. 6, at least one of the display layer 100 or the optical layer 300 may further include a brightness control layer BCLa. FIG. 6 exemplarily illustrates that the optical layer 300 includes the brightness control layer BCLa.

In an embodiment of the present disclosure, the brightness control layer BCLa may overlap the first light emitting area PXAR and may not overlap the second light emitting area PXAG and the third light emitting area PXAB in a plan view. The brightness control layer BCLa may be provided to control the brightness of the light traveling between the first angle AG1 and the second angle AG2. For example, the first angle AG1 may be 60 degrees and the second angle AG2 may be 30 degrees, but the present disclosure is not particularly limited thereto. The brightness control layer BCLa may adjust a color sense by reducing the brightness of the light provided from the first light emitting area PXAR at a specific angle. Thus, as the WAD characteristics are improved, display quality of the electronic device 1000a may be effectively improved.

In an embodiment of the present disclosure, the brightness control layer BCLa may include a first portion BP 1 having a first transmittance and a second portion BP2 having a second transmittance smaller than the first transmittance. The first portion BP1 may be adjacent to a first edge E1 of the brightness control layer BCLa, and the second portion BP2 may be adjacent to a second edge E2 of the brightness control layer BCLa. The brightness control layer BCLa may have a graded transmittance distribution. For example, transmittance of the brightness control layer BCLa may gradually decrease from the first edge E1 to the second edge E2.

In an embodiment of the present disclosure, the transmittance of the brightness control layer BCLa may be smaller than 100 percent and may be higher than the transmittance of the light shielding layer 310. For example, the transmittance of the first portion BP1 of the brightness control layer BCLa may be greater than 82 percent and smaller than 100 percent, and for example, may be greater than or equal to 88 percent and smaller than or equal to 91 percent. The transmittance of the second portion BP2 of the brightness control layer BCLa may be greater than 77 percent and smaller than 100 percent, and for example, may be greater than or equal to 83 percent and smaller than or equal to 86 percent.

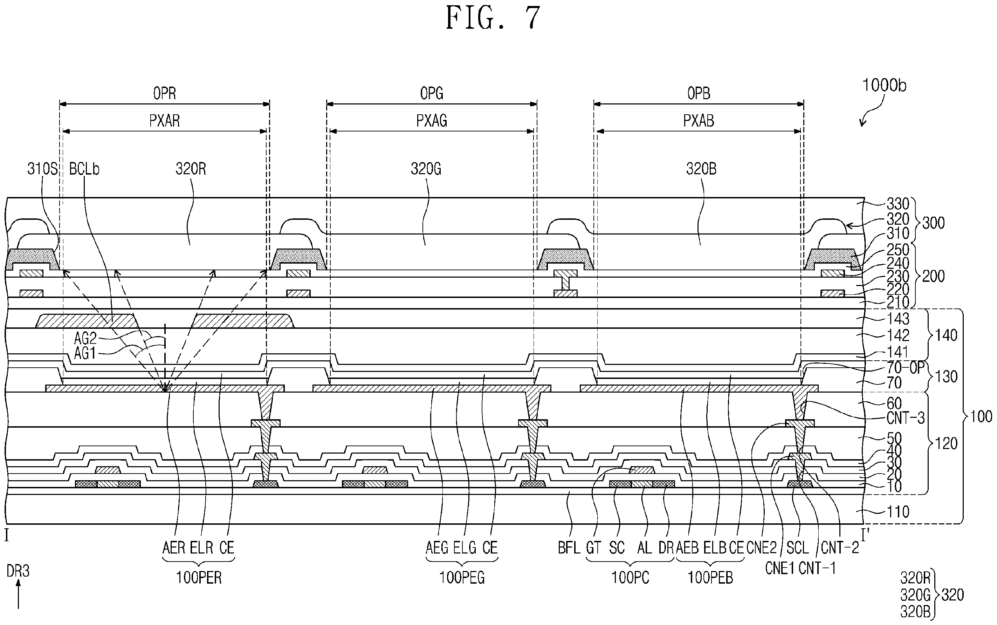

FIG. 7 is a cross-sectional view illustrating a portion of an electronic device 1000b according to an embodiment of the present disclosure. In the description of FIG. 7, the same components as those described in FIG. 5 are designated by the same reference numerals, and a description thereof will be omitted.

Referring to FIG. 7, at least one of the display layer 100 or the optical layer 300 may further include a brightness control layer BCLb. FIG. 7 exemplarily illustrates that the display layer 100 includes the brightness control layer BCLb.

In an embodiment of the present disclosure, the brightness control layer BCLb may be disposed between the first light emitting element 100PER and the first opening OPR. For example, the brightness control layer BCLb may be disposed between the organic layer 142 and the second inorganic layer 143.

In an embodiment of the present disclosure, the brightness control layer BCLb may overlap the first light emitting area PXAR and may not overlap the second light emitting area PXAG and the third light emitting area PXAB in a plan view. The brightness control layer BCLb may be provided to control the brightness of the light traveling between the first angle AG1 and the second angle AG2. For example, the first angle AG1 may be 60 degrees and the second angle AG2 may be 30 degrees, but the present disclosure is not particularly limited thereto. The brightness control layer BCLb may adjust the color sense by reducing the brightness of the light provided from the first light emitting area PXAR at a specific angle. Thus, as the WAD characteristics are improved, display quality of the electronic device 1000b may be effectively improved.

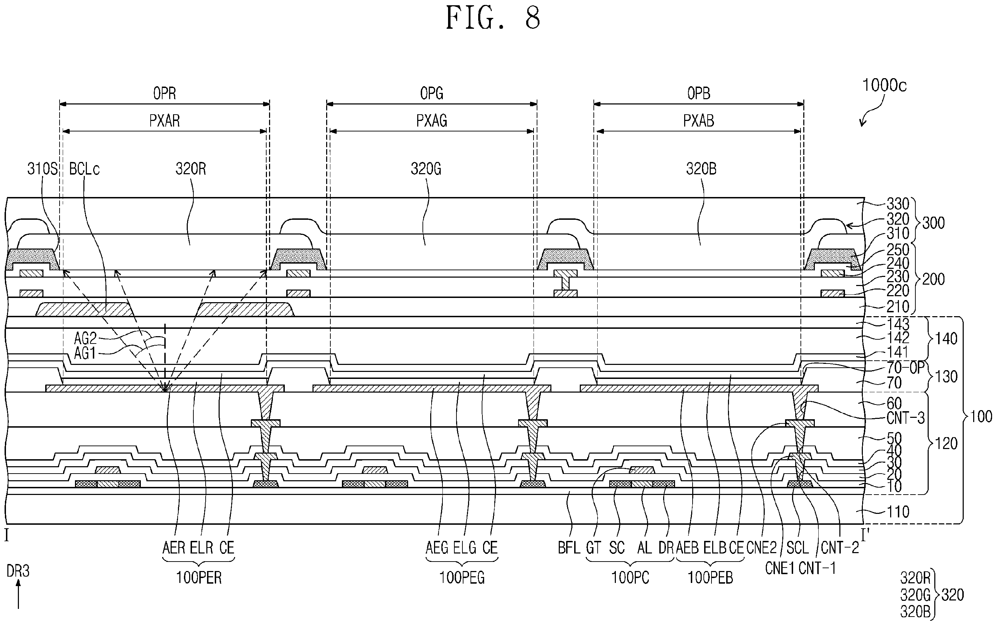

FIG. 8 is a cross-sectional view illustrating a portion of an electronic device 1000c according to an embodiment of the present disclosure. In the description of FIG. 8, the same components as those described in FIG. 5 are designated by the same reference numerals, and a description thereof will be omitted.

Referring to FIG. 8, the sensor layer 200 may further include a brightness control layer BCLc. FIG. 8 exemplarily illustrates that the sensor layer 200 includes the brightness control layer BCLc.

In an embodiment of the present disclosure, the brightness control layer BCLc may be disposed between the first light emitting element 100PER and the first opening OPR. For example, the brightness control layer BCLc may be disposed between the encapsulation layer 140 and the sensor base layer 210.

In an embodiment of the present disclosure, the brightness control layer BCLc may overlap the first light emitting area PXAR and may not overlap the second light emitting area PXAG and the third light emitting area PXAB in a plan view. The brightness control layer BCLc may be provided to control the brightness of the light traveling between the first angle AG1 and the second angle AG2. For example, the first angle AG1 may be 60 degrees and the second angle AG2 may be 30 degrees, but the present disclosure is not particularly limited thereto. The brightness control layer BCLc may adjust a color sense by reducing the brightness of the light provided from the first light emitting area PXAR at a specific angle. Thus, as the WAD characteristics are improved, display quality of the electronic device 1000c may be effectively improved.

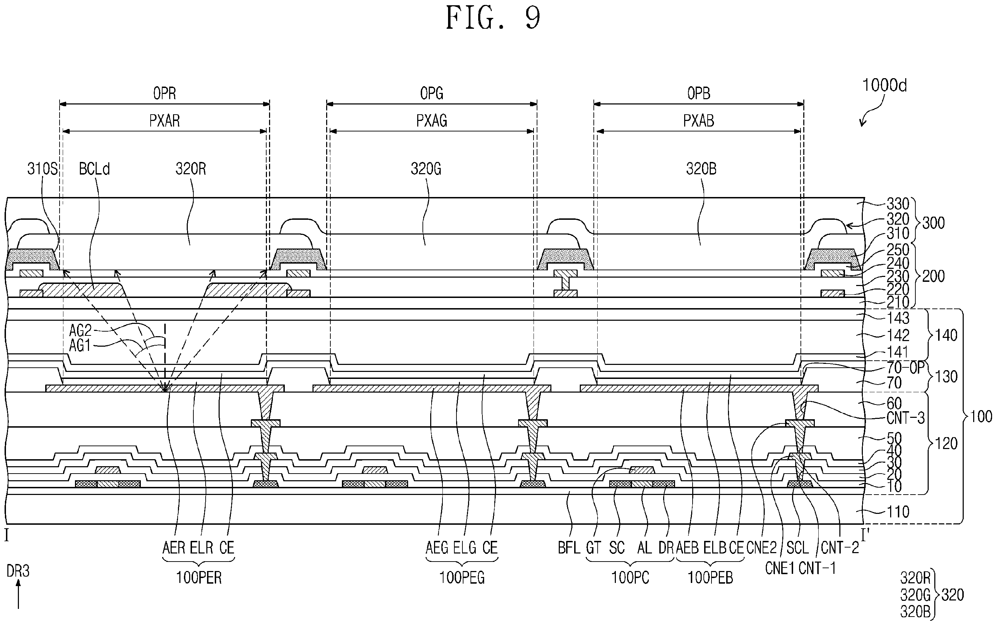

FIG. 9 is a cross-sectional view illustrating a portion of an electronic device 1000d according to an embodiment of the present disclosure. In the description of FIG. 9, the same components as those described in FIG. 5 are designated by the same reference numerals, and a description thereof will be omitted.

Referring to FIG. 9, the sensor layer 200may further include a brightness control layer BCLd. FIG. 9 exemplarily illustrates that the sensor layer 200 includes the brightness control layer BCLd.

In an embodiment of the present disclosure, the brightness control layer BCLd may be disposed between the first light emitting element 100PER and the first opening OPR. For example, the brightness control layer BCLd may be included in the sensor layer 200.

In an embodiment of the present disclosure, the brightness control layer BCLd may overlap the first light emitting area PXAR and may not overlap the second light emitting area PXAG and the third light emitting area PXAB in a plan view. The brightness control layer BCLd may be provided to control the brightness of the light traveling between the first angle AG1 and the second angle AG2. For example, the first angle AG1 may be 60 degrees and the second angle AG2 may be 30 degrees, but the present disclosure is not particularly limited thereto. The brightness control layer BCLd may adjust a color sense by reducing the brightness of the light provided from the first light emitting area PXAR at a specific angle. Thus, as the WAD characteristics are improved, display quality of the electronic device 1000d may be effectively improved.

Each of the brightness control layers BCLb, BCLc, and BCLd described in FIGS. 7 to 9 may be included in the display layer 100 or the sensor layer 200. Thus, each of the brightness control layers BCLb, BCLc, and BCLd may be spaced apart from the light shielding layer 310. A transmittance of each of the brightness control layers BCLb, BCLc, and BCLd may be smaller than 100 percent and greater than the transmittance of the light shielding layer 310. For example, each of the brightness control layers BCLb, BCLc, and BCLd may have a single transmittance as in the brightness control layer BCL illustrated in FIG. 5. Alternatively, each of the brightness control layers BCLb, BCLc, and BCLd may have a graded transmittance distribution like the brightness control layer BCLa illustrated in FIG. 6. In this case, when viewed in the third direction DR3, a transmittance of a portion of each of the brightness control layers BCLb, BCLc, and BCLd, which overlaps or is adjacent to the light shielding layer 310 in a plan view, may be smaller than a transmittance of a portion thereof, which is spaced apart from the light shielding layer 310.

FIG. 10 is a plan view illustrating some components of the electronic device 1000 (see FIG. 5) according to an embodiment of the present disclosure.

Referring to FIGS. 5 and 10, the brightness control layer BCL may have the first edge E1 and the second edge E2 surrounding the first edge E1. Thus, a shape of the brightness control layer BCL may be a ring shape.

In an embodiment of the present disclosure, the display layer 100 or the optical layer 300 may include a brightness control layer BCL. That is, the brightness control layer BCL may be included in at least one of the display layer 100 or the optical layer 300. For example, in the embodiment shown in Figure 5, the brightness control layer BCL may be included in the optical layer 300. Alternatively, in the embodiment shown in Figure 7, the brightness control layer BCL may be included in the display layer 100.

FIG. 10 exemplarily illustrates a first pixel defining opening 70-OPR defined in the pixel defining film 70 and the first opening OPR defined in the light shielding layer 310. A shape of each of the first pixel defining opening 70-OPR and the first opening OPR may be circular. The first pixel defining opening 70-OPR may correspond to the first light emitting area PXAR. A shape of the brightness control layer BCL may have a circular ring shape corresponding to the shapes of the first pixel defining opening 70-OPR and the first opening OPR. However, the shapes of the first pixel defining opening 70-OPR, the first opening OPR, and the brightness control layer BCL are merely examples and are not particularly limited to the illustrated examples.

Dotted lines illustrated in FIG. 10 may correspond to a side wall 70S of the pixel defining film 70 defining the first pixel defining opening 70-OPR and the side wall 310S of the light shielding layer 310 for defining the first opening OPR. A size of the pixel defining opening 70-OPR may be larger than a size of an area surrounded by the first edge E1 of the brightness control layer BCL. Further, a size of the first opening OPR may be larger than the size of the area surrounded by the first edge E1 of the brightness control layer BCL. Further, both the side wall 70S of the pixel defining film 70 and the side wall 310S of the light shielding layer 310 may overlap the brightness control layer BCL in a plan view.

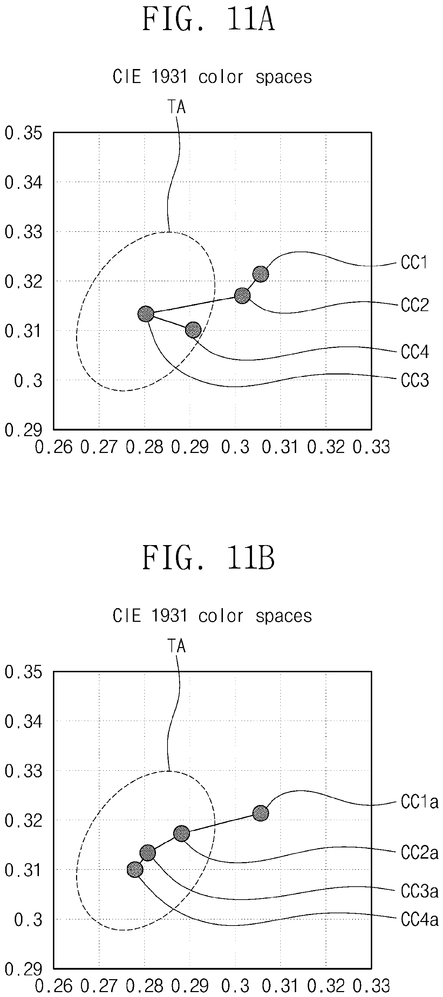

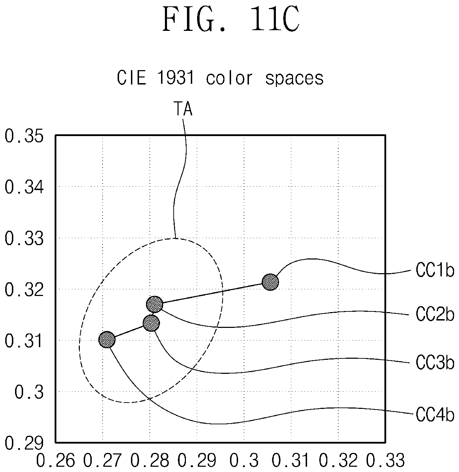

FIG. 11A is a graph depicting color coordinates according to a viewing angle according to a comparative example of the present disclosure. FIG. 11B is a graph depicting color coordinates according to a viewing angle according to an embodiment of the present disclosure. FIG. 11C is a graph depicting color coordinates according to a viewing angle according to a comparative example of the present disclosure.

Referring to FIGS. 11A to 11C, first points CC1, CC1a, and CC1b indicate color coordinates when a viewing angle is zero degree, second points CC2, CC2a, and CC2b indicate color coordinates when a viewing angle is 30 degrees, third points CC3, CC3a, and CC3b indicate color coordinates when a viewing angle is 45 degrees, and fourth points CC4, CC4a, and CC4b indicate color coordinates when a viewing angle is 60 degrees. The viewing angles may mean angles of view inclined with respect to a normal direction of a display area. The normal direction of the display area, that is, the thickness direction of the electronic device 1000, is indicated by the third direction DR3.

Referring to FIG. 5 together, when the viewing angle is 0 degree, white color coordinates of the electronic device 1000 may be adjusted based on determined target color coordinates. Further, the white color coordinates when the viewing angle is 45 degrees may be adjusted to specific color coordinates by adjusting a film thickness of an organic layer included in the display layer 100. For example, the organic layer may be the first to third light emitting layers ELR, ELG, and ELB. A color coordinate target area TA may be determined based on the color coordinates at 45 degrees. When the white color coordinates at 30 degrees and 60 degrees are arranged within the color coordinate target area TA, the electronic device may be evaluated as a good product.

FIG. 11A is a graph depicting a color coordinate change according to a viewing angle when there is no brightness control layer BCL. In this case, the second point CC2 that has color coordinates at 30 degrees may be disposed outside the color coordinate target area TA. Thus, a phenomenon in which the image displayed by the electronic device appears red at a certain viewing angle may occur.

FIG. 11B is a graph depicting a change in color coordinates according to a viewing angle when the transmittance of the brightness control layer BCL is 88 percent according to an embodiment of the present disclosure. Both the second point CC2a that is color coordinates at 30 degrees and the third point CC3a that is color coordinates at 60 degrees may be arranged within the color coordinate target area TA. Thus, a color difference according to a viewing angle may be reduced, and accordingly, display quality or product quality of the electronic device 1000 may be effectively improved.

FIG. 11C is a graph depicting a change in color coordinates according to a viewing angle when the transmittance of the brightness control layer BCL is 82 percent. When the transmittance of the brightness control layer BCL is 82 percent, both the second point CC2b that is color coordinates at 30 degrees and the third point CC3b that is color coordinates at 60 degrees may be arranged within the color coordinate target area TA. However, a color change between the first point CC1b and the second point CC2b may rapidly occur as compared to an embodiment of FIG. 11B. Thus, the transmittance of the brightness control layer BCL may be greater than 82 percent and smaller than 100 percent and may be determined to be, for example, about 88 percent.

According to the above description, an electronic device may include a brightness control layer for improving WAD characteristics. A transmittance of the brightness control layer may be smaller than 100 percent and greater than a transmittance of a light shielding layer. The brightness control layer may adjust a color sense by reducing brightness of a light provided from a specific light emitting area at a specific viewing angle. As the WAD characteristics are improved, display quality of the electronic device may be effectively improved.

Although the description has been made above with reference to an embodiment of the present disclosure, it may be understood that those skilled in the art or those having ordinary knowledge in the art may variously modify and changes the present disclosure without departing from the technical scope of the present disclosure described in the appended claims. Thus, the technical scope of the present disclosure is not limited to the detailed description of the specification, but should be defined by the appended claims.

## Claims

1. An electronic device (1000, 1000-1, 1000a, 1000b, 1000c, 1000d) comprising:
a display layer (100) including a plurality of light emitting elements in which a plurality of light emitting areas are defined; and
an optical layer (300) disposed on the display layer (100),
wherein the optical layer (300) includes:
a light shielding layer (310) in which a plurality of openings (OPR, OPG, OPB) corresponding to the plurality of light emitting areas are defined; and
a plurality of color filters (320) arranged to correspond to the plurality of openings,
wherein the display layer (100) or the optical layer (300) further includes a brightness control layer (BCL) overlapping a first light emitting area among the plurality of light emitting areas and a first opening (OPR) among the plurality of openings (OPR, OPG, OPB) in a plan view, and
wherein the brightness control layer (BCL) includes a first edge (E1) and a second edge (E2) surrounding the first edge (E1), the first edge (E1) overlaps the first light emitting area in the plan view, and the second edge (E2) overlaps the light shielding layer (310) in the plan view.

2. The electronic device (1000, 1000-1, 1000a, 1000b, 1000c, 1000d) of claim 1, wherein a transmittance of the brightness control layer (BCL) is greater than a transmittance of the light shielding layer (310) and smaller than 100 percent.

3. The electronic device (1000, 1000-1, 1000a, 1000b, 1000c, 1000d) of claim 1 or 2, wherein the brightness control layer (BCL) includes a first portion (BC-1) having a first transmittance and a second portion (BC-2) having a second transmittance lower than the first transmittance.

4. The electronic device (1000, 1000-1, 1000a, 1000b, 1000c, 1000d) of claim 3, wherein the first portion (BC-1) is adjacent to the first edge (E1), and the second portion (BC-2) is adjacent to the second edge (E2).

5. The electronic device (1000, 1000-1, 1000a, 1000b, 1000c, 1000d) of any of the preceding claims, wherein the brightness control layer (BCL) overlaps a side wall (70S, 310S) of the light shielding layer (310) defining the first opening (OPR) in the plan view.

6. The electronic device (1000, 1000-1, 1000a, 1000b, 1000c, 1000d) of any of the preceding claims, wherein a first part of the brightness control layer (BCL) is covered by the light shielding layer (310), and a second part of the brightness control layer (BCL) is covered by a first color filter (320R) among the plurality of color filters (320).

7. The electronic device (1000, 1000-1, 1000a, 1000b, 1000c, 1000d) of claim 6, wherein a maximum thickness of the brightness control layer (BCL) is smaller than a maximum thickness of the light shielding layer (310).

8. The electronic device (1000, 1000-1, 1000a, 1000b, 1000c, 1000d) of any of the preceding claims, wherein the display layer (100) further includes:
a base layer (110);
a circuit layer (120) disposed on the base layer (110);
an element layer (130) disposed on the circuit layer (120) and including the plurality of light emitting elements; and
an encapsulation layer (140) disposed on the element layer (130), and
wherein the brightness control layer (BCL) is disposed inside the display layer (100) or on the encapsulation layer (140).

9. The electronic device (1000, 1000-1, 1000a, 1000b, 1000c, 1000d) of claim 8, wherein each of the plurality of light emitting elements includes a first electrode, a light emitting layer disposed on the first electrode, and a second electrode disposed on the light emitting layer,
the element layer (130) further includes a pixel defining film (70) in which a pixel defining opening (70-OP, 70-OPR) overlapping a portion of the first electrode in the plan view is defined, and
a size of the pixel defining opening (70-OP, 70-OPR) is larger than a size of an area surrounded by the first edge (E1) of the brightness control layer (BCL) in the plan view.

10. The electronic device (1000, 1000-1, 1000a, 1000b, 1000c, 1000d) of any of the preceding claims, wherein the plurality of light emitting elements include a first light emitting element (100PER) in which the first light emitting area is defined, a second light emitting element (100PEG) in which a second light emitting area is defined, and a third light emitting element (100PEB, 100PEG, 100PER) in which a third light emitting area is defined,
the plurality of openings (OPR, OPG, OPB) include the first opening (OPR) overlapping the first light emitting area, a second opening (OPG) overlapping the second light emitting area, and a third opening (OPB) overlapping the third light emitting area, and
the first light emitting area is configured to emit a red light, the second light emitting area is configured to emit a green light, and the third light emitting area is configured to emit a blue light.

11. The electronic device (1000, 1000-1, 1000a, 1000b, 1000c, 1000d) of any of the preceding claims, wherein a shape of each of the plurality of openings(OPR, OPG, OPB) is circular in the plan view.

12. The electronic device (1000, 1000-1, 1000a, 1000b, 1000c, 1000d) of any of the preceding claims, wherein the brightness control layer (BCL) is of a ring shape in the plan view.
